# EUROPEAN PATENT SPECIFICATION

(11) **EP 3 389 099 B1**
(45) Date of publication and mention of the grant of the patent: **01.04.2020**
(21) Application number: 17166708.2
(22) Date of filing: 14.04.2017
(51) Int. Cl.: H01L 31/048

(54) **PHOTOVOLTAIC MODULE, PHOTOVOLTAIC ENCAPSULANT AND METHOD OF PRODUCING A PHOTOVOLTAIC MODULE**
PHOTOVOLTAIKMODUL, PHOTOVOLTAISCHER VERKAPSELUNGSSTOFF UND VERFAHREN ZUR HERSTELLUNG EINES PHOTOVOLTAIKMODULS
MODULE PHOTOVOLTAÏQUE, ENCAPSULANT PHOTOVOLTAÏQUE ET PROCÉDÉ DE FABRICATION D'UN MODULE PHOTOVOLTAÏQUE

(43) Date of publication of application: 17.10.2018
(73) Proprietor: Meyer Burger (Switzerland) AG, 3645 Gwatt/Thun (CH)
(72) Inventor: YAO, Yu, 3600 Thun (CH); BEYER, Seda, 79194 Gundelfingen (DE); DESPEISSE, Matthieu, 2000 Neuchâtel (CH); LINE BONNET-EYMARD, Benedicte, 3007 Bern (CH); SÖDERSTRÖM, Thomas, 3604 Thun (CH); LI, Hengyu, 2068 Hauterive (CH); FAES, Antonin, 1462 Yvonand (CH)
(74) Representative: Patentbüro Paul Rosenich AG

(56) References cited:
- EP-A1- 2 892 080
- DE-A1-102011 055 148
- US-A1- 2013 233 376
- US-A1- 2014 144 487

## Description

The invention relates to a photovoltaic module according to the preamble of claim 1. Moreover, the invention relates to a photovoltaic encapsulant, particularly an encapsulant foil or encapsulant granules, and to a method of producing a photovoltaic module, comprising the step of encapsulating a photoactive component, such as a solar cell or a thin film, with an encapsulant. The invention also relates to wire foil or electrode comprising the inventive encapsulant and electrical interconnectors, preferably wires such as is know from WO 2004/021455 A1.

Most solar modules are manufactured by forming a laminate consisting of a glass plate, photoactive elements and a back cover made of glass or formed as a back sheet. These layers are held together to form a laminate by so-called encapsulants: materials adhere to the layers an fill any gaps in the laminate such as spaces between solar cells. These encapsulants may for example contain duroplasts such as EVA, TPSEs (Thermoplastic silicone elastomers), TPUs (thermoplastic polyurethane), TPOs (Thermoplastic polyfin elastomers), ionomers or thermoplasts such as PVB, silicon or polyolefin. Also combinations of thermo- and duroplasts are used: materials that remain thermoplastic but can be cured with suitable means such as heat or electron irradiation. Encapsulants are chosen based on many factors such as cost, place and function in the module (e.g. encapsulant on sunny side of the solar cell must be more transparent than the encapsulant on the shadows side), market expectance etc.

Solar cell (photovoltaic) modules are typically constructed as a laminate with at least five layers in this order: (a) glass layer or other transparent layer, (b) a first or front encapsulant layer, (c) the photoactive component layer, (d) a second or back encapsulant layer, and (e) a back layer such as a back sheet or a glass layer. In the case of thin film solar panels, the photoactive component layer is attached to a glass layer, necessitating only - except for possible interconnectors of the cells of the thin film - to add one layer of encapsulant and a back layer such as a back sheet or a glass layer. The manufacturing method of laminated solar cell modules generally involves placing a piece of encapsulant foil between the solar cell(s) and the other module layers, such as the glass layer and the back- layer. The state of the art uses foils of 400-500µm. The encapsulant layers are designed to encapsulate and protect the brittle solar cell layers from environmental damage and therefore prolong their useful life. Generally, a solar cell module will incorporate at least two encapsulant layers sandwiched around the solar cell layer. The two encapsulant layers can be the same or different materials.

Nowadays, the encapsulant is usually placed in the lay-up before lamination in form of a foil. The lay-up being mainly all materials (except for materials that are cut off after lamination) later formed into the laminate such as a solar panel forming multiple layers. WO2011/089473 discloses the laminating process of a solar panel in detail.

The foil has to be cut, handled and placed correctly on the lay-up. Since modules are quite large this is cumbersome. Also the foil has to be placed in the lay-up correctly and may not shift. This may go wrong resulting in economic lass. Also, foils shrink during lamination. This is due to the production process of the foil. Moreover, it results from liquefying polymer granules and turning that into foil. In addition raw material gets lost during production of the foil, resulting in additional cost.

For the former two reasons (alignment and shrinkage), the foils need to be made bigger than the final module. After lamination the foil (or what is left of it, a sticky mass) sticks out of the module and has to be removed which is not easy until the encapsulant becomes hard after a while, prolonging processing time. Also as long as the protruding foil is soft, it sticks to machine parts such as the conveyer belt it lays on and the membrane used for pressing it together that thus have to be cleaned regularly. Brushes can be provided for this purpose. There are, however, also foils, especially thermoplastic foils, that do not shrink. WO2015/056069A1 discloses the possibility of using granules as encapsulant - alternatively or additionally to foils. WO2014/081999A1 discloses a solar cell module comprising a plurality of solar cells and an encapsulant encapsulating the plurality of solar cells. The encapsulant comprises polyolefin having a complex viscosity less than 10.000 Pa·s at 90°. Table 1 shows complex viscosity in Pa·s of four samples, wherein samples 3 and 4 fulfill above criterion. A protective package is provided for achieving crack resistance, the package including a top cover, the encapsulant, and a backsheet. EP2892080A1 discloses sealing films for a solar cell. The light-receiving side sealing film is formed from a resin composition A and the colored backside sealing film is formed from a resin composition B. The temperature at which the resin composition B has a viscosity of 50.000 Pa·s is 95°C or lower. The resin composition B has a viscosity higher than that of the resin composition A at 80°C and 100°C. US2014/0144487A1 discloses an encapsulant encapsulating the plurality of solar cells, the encapsulant comprising polyolefin. The polyolefin has a complex viscosity less than 30.000 Pa·s at 90°C.

DE102011055148A1 discloses a solar module wherein the back side of the solar module is formed by a polymer backside encapsulant structure.

US2013/0233376A1 discloses a solar cell encapsulant comprising an ethylene/α-oleofin/non-conjugated polyene copolymer.

A main goal in photovoltaics is to reduce the manufacturing costs. The compromise between further reducing the costs and reliability of the photovoltaic modules is the most important challenge of the photovoltaic industry. New concepts are emerging such as SWCT, Shingling, MBB (multi bus bar >4) with the same aim to improve efficiency and reduce material consumption. All those technologies have a tradeoff between reliability and material consumption and mainly interconnection material such as Ag paste, Ag glue, adhesive, and/or soldering alloy. However, all those technologies suffer from a main drawback, i.e. the complex handling of the fragile solar cells or the emerging module during manufacture sets limits to either throughput or yield of the stringer or matrix machines (composing and transporting the emerging module).

Further, due to the different thermal expansion coefficients of the different materials in the photovoltaic module, stresses within the module may over time cause failures or defect areas.

The object of the invention is to overcome these problems and to provide a photovoltaic module having high stability against stresses arising within the module, particularly due to different thermal expansion of different materials. A photovoltaic module should be provided, which module can be manufactured with reduced costs and guaranteeing a reliable performance. The throughput and yields of stringer or matrix machines shall be improved. The fragile photoactive components, particularly solar cells should be protected during the manufacturing process but also during use.

The object is achieved by a photovoltaic module according to claim 1 in that the first complex viscosity amounts to at least 200.000 Pa·s and that the second complex viscosity is less than 100.000 Pa·s.

The high viscosity of the encapsulant ensures high stability and prevents components within the module from being (locally) disconnected or removed/displaced from each other (e.g. by thermal stresses). The inventive encapsulant particularly reliably keeps the electrical interconnectors against the photoactive components. The high viscosity of the encapsulant material may improve the manufacturing process. The mechanical stability allows increasing the throughput and yield of the machines, particularly by increasing the processing velocity. Moreover, failures or defects occurring on the encapsulant material during processing are efficiently reduced. At the same time the mechanical properties of the whole photovoltaic module are improved, yielding a higher stability also at elevated temperatures. Moreover, the stiffer encapsulant, once attached to the solar cells, helps the interconnectors to remain in good electrical contact with the cell.

According to the invention, at a first temperature having a value between 70°C and 100°C the complex viscosity amounts to ≥ 200.000 Pa·s.

The material forming the encapsulant has a complex viscosity which decreases with increasing temperature and thus has thermoplastic properties. As mentioned before, the encapsulant may also contain a curable component. This is important for the lamination process (where the encapsulant melts or at least becomes sticky) usually performed subsequent to the stringer process. Due to the high viscosity in the temperature range of 70° to 100° the handling of the emerging module becomes much easier and the encapsulant tends to flow less, thus preventing "cell swimming". The highly viscose encapsulant - usually provided in form of a (transparent) foil - has high mechanical stability and constitutes a reliable mechanical support for the photoactive components (usually a plurality of solar cells). The structure of multiple photoactive components with the inventive encapsulant of high viscosity ensures that in the stringer and matrix machines the fragile photoactive components are already protected to a high extent. With other words: the encapsulant according to the invention supports the handling, particularly in the stringer or matrix machine and improves the yield and throughput.

Moreover, the high viscosity makes sure that in use the thermocycles the module (or panel) goes through do not lead to too high tensions that could e.g. delaminate the module or disconnect electrical connectors from the cells.

The complex viscosity as given in the present application is determined according to Standard ASTM D5289 and/or ASTM D6204 and is measured at a frequency of 1Hz and 10% strain. Although these standards relate to rubber, the test method defined therein is applicable to all materials described in this application.

The material forming the encapsulant provides a trade-off between thermoplastic properties and cross-linking properties of polymers, in order to achieve the inventive values of complex viscosity. The encapsulant should be a thermoplastic material in the sense that heating it up will result in a lowering of the viscosity. The composition may be achieved by a selection of constituents, additives and fillers. Man skilled in the art is capable of realizing/influencing complex viscosity values by selection of amongst others molecular weight and/or molecular weight distribution and/or considering degree of polymer branching and/or adding fillers to the polymer (key factors are filler size and shape, filler concentration, and the extent of any interactions among the particles) and/or using polymer blends (compositions of chemically different polymers), etc. All these factors have an influence on the rheology of the emerging material.

As starting material e.g. commercially available grade resins, which may be already copolymers, may be used. Further (alternative) material or material components will be described below.

It is preferred if the material at the same time is curable by an electronic radiation or E-beam. Here, the crosslinking yield is selected higher than chain scission yield.

The G value is typically used by radiation chemist to quantify the chemical yield from radiation processing. E-beam is one of the radiation processes that can be applied to polymers. The G value is defined as the chemical yield of radiation in number of molecules reacted per 100eV of absorbed energy. G(X) is the chemical yield of crosslinking, G(S) is the chemical yield of chain scission. These two processes always co-exist under radiation, a net result of crosslinking comes from materials with G(X)>G(S), a net result of degradation comes from materials with G(X)<G(S).

Polymers with more hydrogen atoms on the side (e.g. PE), tend to crosslink. Polymers with methyl group (e.g. polypropylene), di-substitutions (e.g. polymethacrylate) and per-halogen substitutions (e.g. PTFE) would more likely undergo degradation with radiation.

The object is also achieved with a photovoltaic encapsulant according to claim 14, particularly an encapsulant foil or encapsulant granules, wherein the encapsulant is formed from a material having at a first temperature a first complex viscosity and at a second temperature a second complex viscosity, wherein the first complex viscosity is larger than the second complex viscosity and wherein the first temperature is between 70°C and 100°C and the second temperature is between 120°C and 160°C, characterized in that the first complex viscosity amounts to at least 200.000 Pa·s and that the second complex viscosity is less than 100.000 Pa·s, preferably less than 50.000 Pa·s.

The object is also achieved with a method of producing a photovoltaic module according to claim 15, comprising the step of encapsulating a photoactive component, such as a solar cell or a thin film, with an encapsulant according to the invention, wherein preferably at least one electrical interconnector is attached to the encapsulant.

The foregoing and the following embodiments/features are applicable in the same manner to the "photovoltaic module", to the "photovoltaic encapsulant", the "wire foil" and to the "method of producing a photovoltaic module".

The encapsulant with the embedded photoactive components is preferably sandwiched by outer layers (e.g. plates), preferably glass layers.

The second complex viscosity is less than 100.000 Pa·s, more preferred less than 50.000 Pa·s. By having such a complex viscosity at the second temperature (i.e. at a temperature between 120° and 160°) the advantages of thermoplastic (thermos-softening) properties may be used. This is particularly important during the heating procedure such that the encapsulant may 'flow' or snuggle against the photoactive component or the electrical interconnector(s) - without leaving intermediate spaces of air inclusions.

Preferably, the first complex viscosity is at least 5 times, preferably at least 10 times, larger than the second complex viscosity. In such an embodiment the mechanical stability at the (lower) first temperature is replaced by an appropriate softening of the encapsulant's material at the (higher) second temperature.

Preferably, the first complex viscosity is at least 100.000 Pa·s larger than the second complex viscosity, so that the module is stiff during use and the encapsulant can be laminated easily.

Preferably, the second complex viscosity is larger than 5.000, preferably larger than 9.000 Pa·s. Such an embodiment also ensures a degree of mechanical stability during the heating process, i.e. the material of the encapsulant is not deformed or 'squeezed out' of the sandwich structure.

Preferably, the first complex viscosity is less than 1E+10 Pa·s, preferably less than 1E+9 Pa·s. This ensures some elasticity also in the assembled state of the photovoltaic module.

Preferably, the first temperature is between 75°C and 95°C, preferably between 80°C and 90°C, wherein preferably the first temperature amounts to 85°C.

Preferably, the second temperature is between 125°C and 155°C, preferably between 130°C and 150°C, wherein preferably the second temperature amounts to 140°C.

Preferably, the encapsulant is in direct contact with the at least one photoactive component and/or wherein the encapsulant holds at least one electrical interconnector on the photoactive component(s) and/or wherein the encapsulant is provided as a foil and/or as granules.

In a preferred embodiment at least one, preferably a plurality of electrical interconnectors for interconnecting solar cells is attached to the encapsulant. In this embodiment the encapsulant is preferably a foil holding the interconnector(s). The interconnectors may be attached to the encapsulant by means of heating causing a (local) melting of the encapsulant or by means of an adhesive. Such encapsulant foils are e.g. disclosed in EP1547158B1. Such compositions of an encapsulant foil with interconnectors may be used within the scope of the present invention as well. The disclosure of EP1547158B1 is therefore included into the present application by reference.

Preferably, the electrical interconnectors are wires, preferably round wires, having a diameter of less than 1.000 µm, even more preferably less than 500 µm, such as 100 to 300 µm.

With granules or particles any particle form is meant. Preferably, the granules have a diameter smaller than 10mm, preferably smaller than 5mm. The granules preferably result from the manufacturing process, normally containing a compounding or mixing step to add additives to obtain the desired chemical and physical properties.

In a preferred embodiment the manufacturing method comprises the steps of forming a lay-up containing at least a first outer layer, a first encapsulant layer in the form of granules and a second outer layer, and pressing the lay-up together under the influence of heat (and preferably vacuum), preferably in a laminator to form the laminate. The encapsulant in the form of granules may be applied in structured manner.

The concept of using granules - alternatively or additionally to a foil - is e.g. disclosed in WO2015/056069A1, the disclosure of which is included into the present application by reference.

Preferably, the material of the encapsulant has thermoplastic properties. As already mentioned the thermoplastic (thermosoftening) properties are important for the encapsulating process.

Of course the material of the encapsulant may be curable, e.g. by means of an electronic beam.

Preferably, the material of the encapsulant contains a low density polyethylene (LDPE) material or a linear low density polyethylene (LLDPE) material or a medium density polyethylene (MDPE) material.

Preferably, the encapsulant is formed from Polyethylenterephthalat (PET) and/or Polyolefine (PO) and/or Ethylenvinylacetat (EVA) and/or ionomer and/or Polyvinylbutyral (PVB).

Preferably, the density of the material forming the encapsulant is less than 1,5 g/cm3, and preferably larger than 0,7 g/cm3.

Preferably, the encapsulant is a foil layer having a thickness between 10µm and 500 µm, preferably between 40µm and 400µm, and/or wherein the encapsulant is at least 50% transparent for wave lengths of the visible spectrum.

In the following further advantageous properties of the encapsulant material are described:
Preferably, the peel force of the encapsulant to the photoactive component(s) at room temperature amounts to at least 5N/cm at an angle of 90°, preferably after lamination of the module.

Preferably, the peel force of the encapsulant to the electrical (wire) interconnector(s) at room temperature amounts to at least 50mN/wire at an angle of 180°C, preferably prior to lamination of the module.

For the formation of the encapsulant LDPE and LLDPE may be used as mono layer, but also LDPE with MDPE may be used as bilayer where the LDPE acts as adhesive. Each (mono) layer may be treated with E-beam to give it the right properties.

Some density values are given for some encapsulant additions: PET has a density of approximately 1,38g/cm³; PO (Polyolefine, incl. the PE used as electrode foil) has a density between 0,91-0,97 g/cm³, EVA may have a lower density down to 0,85 g/cm³, ionomer 0,94-0,95 g/cm³, PVB 1-1,05 g/cm³.

The shrinkage of the encapsulant is preferably <5%, more preferably <3%, most preferred <0,5%. The shrinkage is measured by heating up the encapsulant (foil) to 160°C for 30 min. Then its dimension is measured before and after thermal treatment in machine direction and transverse direction.

Further embodiments of the invention are indicated in the figures and in the dependent claims. The list of reference marks forms part of the disclosure. The invention will now be explained in detail by the drawings. In the drawings:
- Fig. 1: shows a photovoltaic module emerging from the stringer or matrix machine and before the lamination process,
- Fig. 2: shows a photovoltaic module after the lamination process with completely encapsulated photoactive components,
- Fig. 3: shows an embodiment of the encapsulant in form of a foil to which electrical interconnectors (in form of wires) are attached,
- Fig. 4: shows the complex viscosity of possible materials (samples 1 to 3) forming the inventive encapsulant,
- Fig. 5: shows a lay-up of photoactive components covered by an encapsulant foil having electrical interconnectors and further covered by outer encapsulant foil.

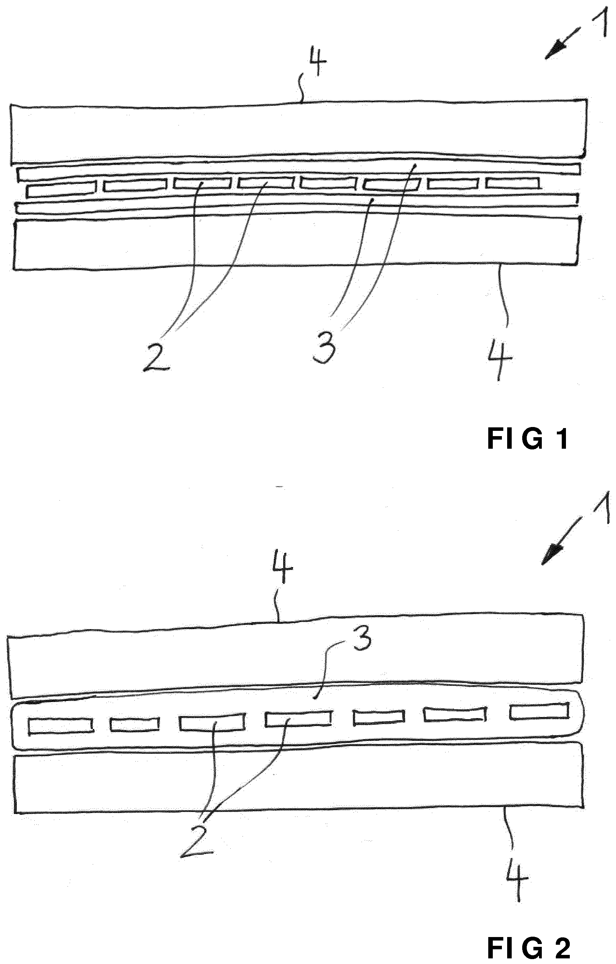

Fig. 1 shows a photovoltaic module 1 comprising solar cells as photoactive components 2 and an encapsulant 3 covering the photoactive components 2 from both sides. Here, the encapsulant is provided in form of foils. However, arranging granules as encapsulant material below and above the photoactive components 2 would be possible as well, as e.g. disclosed in WO2015/056069A1.

The encapsulant 3 with the embedded photoactive components 2 is sandwiched by outer layers 4 on both sides. The outer layers 4 are usually glass plates.

Fig. 2 shows the module 1 after lamination, wherein the photoactive components are completely encapsulated.

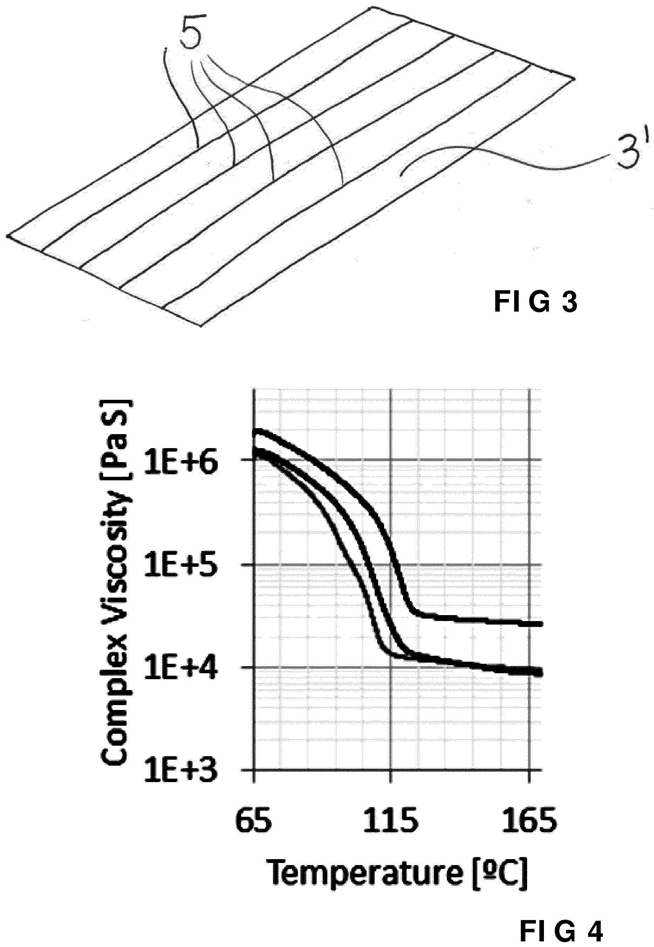

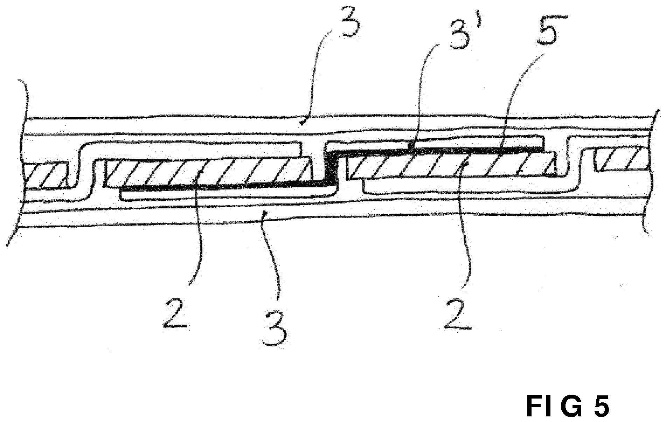

Fig. 5 shows an embodiment, in which encapsulants 3 and 3' are used. Encapsulant 3' is an encapsulant foil with electrical interconnectors 5 attached thereto (as e.g. shown in Fig. 3). Encapsulant 3 covers encapsulant 3'. In an alternative embodiment only encapsulant 3' may be used, i.e. without an additional encapsulant 3. The invention relates to both, an encapsulant (foil) with electrical interconnectors and an encapsulant (foil) without electrical interconnector.

The encapsulant 3, 3' is formed from a material having at a first temperature a first complex viscosity and at a second temperature a second complex viscosity. The first complex viscosity is larger than the second complex viscosity. The first temperature is a temperature between 70°C and 100°C and the second temperature is a temperature between 120°C and 160°C. The first temperature has to be understood as a discrete temperature (not as a temperature range) having a value between 70°C and 100°C, e.g. 85°C. Also, the second temperature has to be understood as a discrete temperature (not as a temperature range) having a value between 120°C and 160°C, e.g. 140°C.

According to the invention the first complex viscosity amounts to at least 200.000 Pa·s. As already mentioned the high viscosity of the encapsulant material may improve the manufacturing process. The mechanical stability allows increasing the throughput and yield of the machines, particularly by increasing the processing velocity. Moreover, failures or defects occurring on the encapsulant material can be efficiently reduced. At the same time the mechanical properties of the whole photovoltaic module are improved, yielding a higher stability also at elevated temperatures.

Fig. 4 shows for three samples the complex viscosity (y axis is a log10 scale) in dependence of the temperature. The samples have been prepared from a low density polyethylene (LDPE) material, provided in the form of copolymers. The viscosity has been optimized starting from the polymer basis by additives/fillers. The main factors of influencing rheologic properties of materials have been already mentioned above.

In the materials shown in Fig. 4, the complex viscosity is larger than 100.000 Pa·s in the whole temperature range from 70°C to 100°C.

The second complex viscosity is less than 100.000 Pa·s, more preferred less than 50.000 Pa·s.

As can be seen from the samples of Fig. 4 the first complex viscosity is at least 5 times (here even at least 10 times) larger than the second complex viscosity.

It is preferred, if the second complex viscosity is still larger than 5.000, preferably larger than 9.000 Pa·s.

The first complex viscosity may be less than 1E+10 Pa·s, preferably less than 1E+9 Pa·s.

The first temperature can be further defined as having a value between 75°C and 95°C, preferably between 80°C and 90°C. In a most preferred embodiment the first temperature amounts to 85°C.

The second temperature can be further defined as having a value between 125°C and 155°C, preferably between 130°C and 150°C. In a most preferred embodiment the first temperature amounts to 140°C.

As can be seen from Fig. 1 and 2 the encapsulant 3 is in direct contact with the photoactive components 2. In the embodiment of Fig. 3 the foil encapsulant 3' holds electrical interconnectors 5 in form of parallel wires or strips (for interconnecting the photoactive components 2). In a pre-fabrication step the interconnector wires are attached to the encapsulant foil by adhesive or by means of a (local) heating process making the encapsulant material becoming sticky. In such a prefabricated state the encapsulant 3' (with integrated interconnectors 5) is arranged on the photoactive components 2. Complete strings and even matrices may be built this way that are then placed in the lay-up as shown in Fig. 1.

As can be seen from Fig. 4 the material of the encapsulant 3 has thermoplastic properties, i.e. the material softens with increasing temperature.

The material of the encapsulant 3 may be formed from or contain a low density polyethylene (LDPE) material and/or a linear low density polyethylene (LLDPE) material and/or a medium density polyethylene (MDPE) material.

Particularly, the encapsulant 3 may be formed from Polyethylenterephthalat (PET) and/or Polyolefine (PO) and/or Ethylenvinylacetat (EVA) and/or ionomer and/or Polyvinylbutyral (PVB).

The density of the material forming the encapsulant 3 may be less than 1,5 g/cm3, and preferably larger than 0,7 g/cm3.

The encapsulant 3 may be a foil layer (Fig. 1) having a thickness between 10µm and 500 µm, preferably between 40µm and 400µm. It is preferred, if the encapsulant 3 is at least 50% transparent for wave lengths of the visible spectrum.

The method of producing a photovoltaic module 1 comprises the step of encapsulating a photoactive component 2, such as a solar cell or a thin film, with an encapsulant 3, wherein preferably at least one electrical interconnector 5 is attached to the encapsulant 3.

Attachment of at least one interconnector 5 is done before arranging the encapsulant 3 on the at least one photoactive component 2.

The invention is not restricted to these embodiments. Other variants will be obvious for the person skilled in the art and are considered to lie within the scope of the invention as formulated in the following claims. Individual features described in all parts of the above specification, particularly with respect to the figures may be combined with each other to form other embodiments and/or applied mutatis mutandis to what is described in the claims and to the rest of the description, even if the features are described in respect to other features.

### List of reference signs

- 1: photovoltaic module
- 2: photoactive component
- 3: encapsulant
- 4: outer layer
- 5: Electrical interconnector

## Claims

1. Photovoltaic module (1) comprising
- at least one photoactive component (2), such as a solar cell or a thin film, and
- an encapsulant (3, 3') covering the at least one photoactive component (2) on at least one side,
wherein the encapsulant (3, 3') is formed from a material having at a first temperature a first complex viscosity and at a second temperature a second complex viscosity, wherein the first complex viscosity is larger than the second complex viscosity, wherein the complex viscosity is determined according to Standard ASTM D5289 and/or ASTM D6204 and is measured at a frequency of 1 Hz and 10% strain, wherein the first temperature is between 70°C and 100°C and the second temperature is between 120°C and 160° C, and wherein the second complex viscosity is less than 100.000 Pa·s,
**characterized in that** the first complex viscosity amounts to at least 200.000 Pa·s.

2. Photovoltaic module according to claim 1, **wherein** the second complex viscosity is less than 50.000 Pa·s.

3. Photovoltaic module according to claim 1 or 2, **wherein** the first complex viscosity is at least 5 times, preferably at least 10 times, larger than the second complex viscosity.

4. Photovoltaic module according to one of the preceding claims, **wherein** the second complex viscosity is larger than 5.000, preferably larger than 9.000 Pa·s.

5. Photovoltaic module according to one of the preceding claims, **wherein** the first complex viscosity is less than 1E+10 Pa·s, preferably less than 1E+9 Pa·s.

6. Photovoltaic module according to one of the preceding claims, **wherein** the first temperature is between 75°C and 95°C, preferably between 80°C and 90°C, wherein preferably the first temperature amounts to 85°C.

7. Photovoltaic module according to one of the preceding claims, **wherein** the second temperature is between 125°C and 155°C, preferably between 130°C and 150°C, wherein preferably the second temperature amounts to 140°C.

8. Photovoltaic module according to one of the preceding claims, **wherein** the encapsulant (3, 3') is in direct contact with the at least one photoactive component (2) and/or wherein at least one electrical interconnector (5) is sandwiched between the encapsulant (3, 3') and the photoactive component (2) and/or wherein the encapsulant (3, 3') holds at least one electrical interconnector (5) on the photoactive component(s) (2) and/or wherein the encapsulant (3, 3') is provided as a foil and/or as granules.

9. Photovoltaic module according to one of the preceding claims, **wherein** the material of the encapsulant (3, 3') has thermoplastic properties.

10. Photovoltaic module according to one of the preceding claims, **wherein** the material of the encapsulant (3, 3') contains a low density polyethylene (LDPE) material and/or a linear low density polyethylene (LLDPE) material and/or a medium density polyethylene (MDPE) material.

11. Photovoltaic module according to one of the preceding claims, **wherein** the encapsulant (3, 3') is formed from Polyethylenterephthalat (PET) and/or Polyolefine (PO) and/or Ethylenvinylacetat (EVA) and/or ionomer and/or Polyvinylbutyral (PVB).

12. Photovoltaic module according to one of the preceding claims, **wherein** the density of the material forming the encapsulant (3, 3') is less than 1,5 g/cm³, and preferably larger than 0,7 g/cm³.

13. Photovoltaic module according to one of the preceding claims, **wherein** the encapsulant (3, 3') is a foil layer having a thickness between 10µm and 500 µm, preferably between 40µm and 400µm, and/or wherein the encapsulant (3, 3') is at least 50% transparent for wave lengths of the visible spectrum.

14. Photovoltaic encapsulant (3, 3'), particularly an encapsulant foil or encapsulant granules, wherein the encapsulant (3, 3') is formed from a material having at a first temperature a first complex viscosity and at a second temperature a second complex viscosity, wherein the first complex viscosity is larger than the second complex viscosity, wherein the complex viscosity is determined according to Standard ASTM D5289 and/or ASTM D6204 and is measured at a frequency of 1Hz and 10% strain, wherein the first temperature is between 70°C and 100°C and the second temperature is between 120°C and 160°C, and wherein the second complex viscosity is less than 100.000 Pa·s, preferably less than 50.000 Pa·s, **characterized in that** the first complex viscosity amounts to at least 200.000 Pa·s, wherein preferably at least one electrical interconnector (5) for interconnecting photoactive components (2) is attached to the encapsulant (3, 3').

15. Method of producing a photovoltaic module (1), comprising the step of encapsulating at least one photoactive component (2), such as a solar cell or a thin film, with an encapsulant (3, 3') according to claim 14, wherein preferably at least one electrical interconnector (5) is attached to the encapsulant (3, 3').

## Patentansprüche

1. Fotovoltaisches Modul (1), das Folgendes umfasst
- mindestens ein fotovoltaisches Bauteil (2), wie eine Solarzelle oder einen Dünnfilm, und
- ein Verkapselungsmaterial (3, 3'), das das mindestens eine fotoaktive Bauteil (2) auf mindestens einer Seite bedeckt,
wobei das Kapselungsmaterial (3, 3') aus einem Material gebildet ist, das bei mindestens einer ersten Temperatur eine erste komplexe Viskosität aufweist, und bei einer zweiten Temperatur eine zweite komplexe Viskosität aufweist, wobei die erste komplexe Viskosität größer ist als die zweite komplexe Viskosität, wobei die komplexe Viskosität gemäß der Norm ASTM D5289 und/oder ASTM D6204 bestimmt wird und bei einer Frequenz von 1 kHz und 10 % Belastung gemessen wird, wobei die erste Temperatur zwischen 70 °C und 100 °C liegt, und die zweite Temperatur zwischen 120 °C und 160 °C liegt, und wobei die zweite komplexe Viskosität kleiner ist als 100.000 Pa·s,
**dadurch gekennzeichnet, dass** die erste komplexe Viskosität mindestens 200.000 Pa·s beträgt.

2. Fotovoltaisches Modul nach Anspruch 1, wobei die zweite komplexe Viskosität kleiner ist als 50.000 Pa·s.

3. Fotovoltaisches Modul nach Anspruch 1 oder 2, wobei die erste komplexe Viskosität mindestens 5 Mal, vorzugsweise mindestens 10 Mal größer ist als die zweite komplexe Viskosität.

4. Fotovoltaisches Modul gemäß einem der vorstehenden Ansprüche, wobei die zweite komplexe Viskosität größer ist als 5.000, vorzugsweise größer als 9.000 Pa·s.

5. Fotovoltaisches Modul nach einem der vorstehenden Ansprüche, wobei die erste komplexe Viskosität kleiner ist als 1E+10 Pa·s, vorzugsweise kleiner als 1E+9 Pa·s

6. Fotovoltaisches Modul nach einem der vorstehenden Ansprüche, wobei die erste Temperatur zwischen 75 °C und 95 °C, vorzugsweise zwischen 80 °C und 90 °C liegt, wobei vorzugsweise die erste Temperatur 85 °C beträgt.

7. Fotovoltaisches Modul nach einem der vorstehenden Ansprüche, wobei die zweite Temperatur zwischen 125 °C und 155 °C, vorzugsweise zwischen 130 °C und 150 °C liegt, wobei die zweite Temperatur vorzugsweise 140 °C beträgt.

8. Fotovoltaisches Modul nach einem der vorstehenden Ansprüche, wobei das Verkapselungsmaterial (3, 3') in direktem Kontakt mit dem mindestens einen fotoaktiven Bauteil (2) ist, und/oder wobei mindestens ein elektrischer Zwischenverbinder (5) zwischen dem Verkapselungsmaterial (3, 3') und dem fotoaktiven Bauteil (2) ins Sandwich genommen ist, und/oder wobei das Verkapselungsmaterial (3, 3') mindestens einen elektrischen Zwischenverbinder (5) auf dem (den) fotoaktiven Bauteil(en) (2) hält, und/oder wobei das Verkapselungsmaterial (3, 3') als eine Folie und/oder als Körnchen bereitgestellt wird.

9. Fotovoltaisches Modul nach einem der vorstehenden Ansprüche, wobei das Material des Verkapselungsmaterials (3, 3') thermoplastische Eigenschaften aufweist.

10. Fotovoltaisches Modul nach einem der vorstehenden Ansprüche, wobei das Material des Verkapselungsmaterials (3, 3') niedrigdichtes Polyethylenmaterial (LDPE) enthält, und/oder ein lineares niedrigdichtes Polyethylenmaterial (LLDPE), und/oder ein mitteldichtes Polyethylenmaterial (MDPE).

11. Fotovoltaisches Modul nach einem der vorstehenden Ansprüche, wobei das Verkapselungsmaterial (3, 3') aus Polyethylenterephthalat (PET) und/oder Polyolefin (PO) und/oder Ethylenvinylacetat (EVA) und/oder Ionomer und/oder Polyvinylbutyral (PVB) gebildet ist.

12. Fotovoltaisches Modul nach einem der vorstehenden Ansprüche, wobei die Dichte des Materials, das das Verkapselungsmaterial (3, 3') bildet, weniger als 1,5 g/cm³ und vorzugsweise größer als 0,7 g/cm³ ist.

13. Fotovoltaisches Modul nach einem der vorstehenden Ansprüche, wobei das Verkapselungsmaterial (3, 3') eine Folienschicht ist, die eine Stärke zwischen 10 µm und 500 µm, vorzugsweise zwischen 40 µm und 400 µm aufweist, und/oder wobei das Verkapselungsmaterial (3, 3') zu mindestens 50 % für Wellenlängen des sichtbaren Spektrums durchlässig ist.

14. Fotovoltaisches Verkapselungsmaterial (3, 3'), insbesondere eine Verkapselungsfolie oder Verkapselungskörner, wobei das Verkapselungsmaterial (3, 3') aus einem Material gebildet ist, das bei einer ersten Temperatur eine erste komplexe Viskosität aufweist, und bei einer zweiten Temperatur eine zweite komplexe Viskosität, wobei die erste komplexe Viskosität größer ist als die zweite komplexe Viskosität, wobei die komplexe Viskosität gemäß der Norm ASTM D5289 und/oder ASTM D6204) bestimmt wird, und bei einer Frequenz von 1 Hz und 10 % Belastung gemessen wird, wobei die erste Temperatur zwischen 70 °C und 100 °C liegt, und die zweite Temperatur zwischen 120 °C und 160 °C, und wobei die zweite komplexe Viskosität kleiner ist als 100.000 Pa·s, vorzugsweise kleiner als 50.000 Pa·s,
**dadurch gekennzeichnet, dass** die erste komplexe Viskosität mindestens 200.000 Pa·s beträgt, wobei vorzugsweise mindestens ein elektrischer Zwischenverbinder (5) zum Verbinden fotoaktiver Bauteile (2) an dem Verkapselungsmaterial (3, 3') angebracht ist.

15. Verfahren zum Erzeugen eines fotovoltaischen Moduls (1), das den Schritt des Verkapselns mindestens eines fotoaktiven Bauteils (2), wie einer Solarzelle oder eines Dünnfilms, mit einem Verkapselungsmaterial (3, 3') nach Anspruch 14 umfasst, wobei vorzugsweise mindestens ein elektrischer Zwischenverbinder (5) an dem Verkapselungsmaterial (3, 3') angebracht ist.

## Revendications

1. Module photovoltaïque (1) comprenant
- au moins un composant photoactif (2), tel qu'une cellule solaire ou une couche mince, et
- un encapsulant (3, 3') qui recouvre ledit au moins un composant photoactif (2) sur au moins un côté,
dans lequel l'encapsulant (3, 3') est constitué d'un matériau présentant à une première température une première viscosité complexe et à une deuxième température une deuxième viscosité complexe, dans lequel la première viscosité complexe est supérieure à la deuxième viscosité complexe, dans lequel la viscosité complexe est déterminée conformément à la norme ASTM D5289 et/ou ASTM D6204 et est mesurée à une fréquence de 1 Hz et une déformation de 10 %, dans lequel la première température est comprise entre 70 °C et 100 °C et la deuxième température est comprise entre 120 °C et 160 °C, et dans lequel la deuxième viscosité complexe est inférieure à 100.000 Pa·s,
**caractérisé en ce que** la première viscosité complexe est d'au moins 200.000 Pa·s.

2. Module photovoltaïque selon la revendication 1, dans lequel la deuxième viscosité complexe est inférieure à 50.000 Pa·s.

3. Module photovoltaïque selon la revendication 1 ou 2, dans lequel la première viscosité complexe est au moins 5 fois, et de préférence au moins 10 fois, supérieure à la deuxième viscosité complexe.

4. Module photovoltaïque selon l'une des revendications précédentes, dans lequel la deuxième viscosité complexe est supérieure à 5.000 Pa·s, et de préférence supérieure à 9.000 Pa·s.

5. Module photovoltaïque selon l'une des revendications précédentes, dans lequel la première viscosité complexe est inférieure à 1E+10 Pa·s, et de préférence inférieure à 1E+9 Pa·s.

6. Module photovoltaïque selon l'une des revendications précédentes, dans lequel la première température est comprise entre 75 °C et 95 °C, et de préférence entre 80 °C et 90 °C, dans lequel la première température est de préférence de 85 °C.

7. Module photovoltaïque selon l'une des revendications précédentes, dans lequel la deuxième température est comprise entre 125°C et 155°C, de préférence entre 130 °C et 150 °C, dans lequel la deuxième température est de préférence de 140 °C.

8. Module photovoltaïque selon l'une des revendications précédentes, dans lequel l'encapsulant (3, 3') est en contact direct avec ledit au moins un composant photoactif (2) et/ou dans lequel au moins un connecteur électrique (5) est intercalé entre l'encapsulant (3, 3') et le composant photoactif (2) et/ou dans lequel l'encapsulant (3, 3') contient au moins un connecteur électrique (5) sur le ou les composants photoactifs (2) et/ou dans lequel l'encapsulant (3, 3') est pourvu comme une feuille et/ou des granules.

9. Module photovoltaïque selon l'une des revendications précédentes, dans lequel le matériau de l'encapsulant (3, 3') présente des propriétés thermoplastiques.

10. Module photovoltaïque selon l'une des revendications précédentes, dans lequel le matériau de l'encapsulant (3, 3') contient un matériau polyéthylène basse densité (LDPE) et/ou un matériau polyéthylène basse densité linéaire (LLDPE) et/ou un matériau polyéthylène moyenne densité (MDPE).

11. Module photovoltaïque selon l'une des revendications précédentes, dans lequel l'encapsulant (3, 3') est constitué de polytéréphtalate d'éthylène (PET) et/ou de polyoléfine (PO) et/ou d'éthylène-acétate de vinyle (EVA) et/ou d'ionomère et/ou de polybutyral vinylique (PVB).

12. Module photovoltaïque selon l'une des revendications précédentes, dans lequel la densité du matériau constituant l'encapsulant (3, 3') est inférieure à 1,5 g/cm³, et de préférence supérieure à 0,7 g/cm³.

13. Module photovoltaïque selon l'une des revendications précédentes, dans lequel l'encapsulant (3, 3') est une couche de feuille présentant une épaisseur comprise entre 10 µm et 500 µm, et de préférence entre 40 µm et 400 µm, et/ou dans lequel l'encapsulant (3, 3') est au moins transparent à 50 % pour les longueurs d'onde du spectre visible.

14. Encapsulant photovoltaïque (3, 3'), en particulier une feuille d'encapsulant ou des granules d'encapsulant, dans lequel l'encapsulant (3, 3') est constitué d'un matériau présentant à une première température une première viscosité complexe et à une deuxième température une deuxième viscosité complexe, dans lequel la première viscosité complexe est supérieure à la deuxième viscosité complexe, dans lequel la viscosité complexe est déterminée conformément à la norme ASTM D5289 et/ou ASTM D6204 et est mesurée à une fréquence de 1 Hz et une déformation de 10 %, dans lequel la première température est comprise entre 70 °C et 100 °C et la deuxième température est comprise entre 120 °C et 160 °C, et dans lequel la deuxième viscosité complexe est inférieure à 100.000 Pa·s, et de préférence inférieure à 50.000 Pa·s,
**caractérisé en ce que** la première viscosité complexe est d'au moins 200.000 Pa·s, dans lequel au moins un connecteur électrique (5) pour interconnecter des composants photoactifs (2) est de préférence attaché à l'encapsulant (3, 3').

15. Procédé de production d'un module photovoltaïque (1), comprenant l'étape d'encapsulation d'au moins un composant photoactif (2), tel qu'une cellule solaire ou une couche mince, avec un encapsulant (3, 3') selon la revendication 14, dans lequel au moins un connecteur électrique (5) est de préférence attaché à l'encapsulant (3, 3').
